# EUROPEAN PATENT APPLICATION

(11) **EP 2 278 623 A2**
(43) Date of publication of application: **26.01.2011**
(21) Application number: 10175735.9
(22) Date of filing: 10.12.2008
(51) Int. Cl.: H01L 31/0224

(54) **Photovoltaic panel and cell with fine fingers and method of manufacturing the same**

(30) Priority: 11.12.2007 US 12795 P; 18.04.2008 US 46045 P; 09.07.2008 US 79178 P
(62) Divisional of application: 08858831.4
(71) Applicant: Evergreen Solar, Inc., Marlborough MA 01752 (US)
(72) Inventor: Ralli, Michael A., Holden, MA 01520 (US); Dube, Christopher E., Lexington, MA 02421 (US); Fox, Stephen, Leicester, MA 01524 (US); Gabor, Andrew, Providence, RI 02906 (US); Williams, Brown, Boston, MA 02109 (US)
(74) Representative: HOFFMANN EITLE

(57) **Abstract**

A photovoltaic cell comprising:
a photosensitive substrate;
a plurality of fingers in ohmic contact with the substrate, at least one of the fingers having an average width of less than about 95 microns;
a plurality of busbars in ohmic contact with the fingers, the busbars having an outer dimension in a range from 100 microns to 500 microns,

the busbars intersecting the fingers, the busbars being spaced less than about 38 millimeters apart, but no closer than 6 mm apart.

## Description

### FIELD OF THE INVENTION

The invention generally relates to photovoltaic cells and panels and, more particularly, the invention relates to photovoltaic cell efficiency using fine fingers.

### BACKGROUND OF THE INVENTION

Photovoltaic cells convert light into electrical energy. To that end, a photovoltaic cell has a doped substrate that, when exposed to light, generates charge carriers, such as electrons. Conductors (referred to in the art as a "tabs") coupled with the substrate conduct these electrons to another device, thus producing an electrical current. As an example, one common cell technology collects the charge carriers by forming a plurality of conductive fingers on the substrate. The fingers conduct the collected charge carriers to one or more of the tabs for transmission to another device.

Problems arise when any of the fingers brealc-i.e., when a discontinuity forms along any of the fingers-or when the fingers otherwise have some kind of discontinuity. This is especially problematic when screen printing the fingers onto the substrate. If that happens, electrons may have to travel farther to reach another, less proximate tab, thus losing energy. These phenomena undesirably reduce cell efficiency.

Those in the art have responded to this problem by forming relatively wide, robust fingers. For example, to the inventors' knowledge, current state of the art, commercially acceptable cell finger printing processes do not form fingers narrower than about 100-120 microns (i.e., having average widths of less than about 100-120 microns). Forming fingers with such large widths often desirably reduces the incidence of breakage.

Wide fingers typically also are more conductive than narrower fingers for a given height. Accordingly, wide fingers should deliver improved current flow from the cell - to deliver commercially acceptable performance. Undesirably, however, wide fingers present another problem; namely, they cover a greater area of the top surface of the cell than that covered by narrower fingers. Thus, as known by those in the art, such greater coverage necessarily reduces the amount of light striking its photosensitive top surface, consequently offsetting efficiency gains by increased finger conductivity.

### SUMMARY OF THE INVENTION

In accordance with one embodiment of the invention, a photovoltaic cell has a photosensitive substrate and a plurality of fingers in ohmic contact with the substrate. At least one of the fingers has an average width of less than about 95 microns. The cell also has a plurality of busbars in ohmic contact with the fingers. At least two of the busbars that are spaced less than about 38 millimeters apart intersect the at least one finger (i.e., the finger(s) having an average width of less than about 95 microns).

As a lower limit, the at least two busbars may be spaced no less than about six millimeters apart. Moreover, in certain applications, no busbar on the substrate may be spaced more than about 38 millimeters from another adjacent busbar. For example, the plurality of busbars may be generally equally spaced apart a given distance of no more than about 15 millimeters.

Any of a number of different substrates may suffice. For example, the substrate may be a sheet wafer formed from doped polysilicon (e.g., a string ribbon wafer having a thickness of no greater than about 300 microns). Each busbar and each finger may be formed from a screen printed conductive material. Moreover, the plurality of fingers preferably are formed from only a single layer of conductive material.

Each of the plurality of intersected fingers may have an average height of no greater than about twenty microns, and an average width of no greater than about sixty microns. Alternatively, each of the plurality of fingers may have an average width of no greater than about 65 microns. In a similar manner, the at least one finger may have an average width of no less than about 35 microns.

The cell may further have a plurality of tabs in ohmic contact with the plurality of busbars. The plurality of tabs also may have a generally planar surface that forms an acute angle with the substrate. The fingers, tabs and busbars together may be configured to cover no more than about six percent of the top surface of the substrate.

At least one of the busbars may be discontinuous and thus, be formed from a plurality of spaced pads. In a similar manner, at least one of the fingers may have a repeating discontinuity and thus, be discontinuous (by design).

To secure a tab (e.g., from another cell) to the bottom face of the substrate, the photovoltaic cell also may have a conductive sheet secured to the bottom face of the substrate. The tab thus is secured between the conductive sheet and the bottom face of the substrate.

In accordance with another embodiment of the invention, a method of fabricating a photovoltaic cell provides a photosensitive substrate having a top face, and deposits a plurality of fingers onto the top face of the substrate and into ohmic contact with the substrate. The plurality of fingers each have an average width of less than about 95 microns. Before, after, or at the same time as depositing the fingers, the method also deposits a plurality of busbars on the top face of the substrate to intersect the plurality of fingers. The plurality of busbars have an outer dimension of greater than about 95 microns. At least two of the plurality of busbars are deposited on the top face of the substrate so that they are separated by no more than about 38 millimeters.

The method as defined by claim 18 wherein depositing a plurality of fingers comprises depositing no more than one layer of conductive material onto the substrate to form the fingers.

After forming the busbars, the method also may electrically connect a tab to at least one of the one layer fingers (e.g., by connecting the tab to the appropriate busbar(s)). In illustrative embodiments, the method deposits the plurality of fingers using a screen printing process.

The method as defined by claim 18 wherein depositing a plurality of fingers comprises depositing a substantially continuous line of conductive material across the front face of the substrate to form a single, substantially continuous finger.

The method may deposit the plurality of fingers by depositing a substantially continuous line of conductive material across the front face of the substrate to form a single, substantially continuous finger. This single, substantially continuous finger may have an irregular break formed after depositing the plurality of fingers. Alternatively, the plurality of fingers may be deposited by depositing a line of conductive material with a regularly spaced discontinuity (i.e., a regularly, repeating discontinuity).

In accordance with another embodiment of the invention, a photovoltaic cell has a photosensitive substrate, and a plurality of spaced pads in ohmic contact with the substrate. The plurality of pads form a plurality of discontinuous busbars and each have an outer dimension that is greater than 100 microns. Each pad in a set of the plurality of pads has a contiguous finger portion extending therefrom. Each such contiguous finger portion has an average width of no greater than about 95 microns.

### BRIEF DESCRIPTION OF THE DRAWINGS

Those skilled in the art should more fully appreciate advantages of various embodiments of the invention from the following "Description of Illustrative Embodiments," discussed with reference to the drawings summarized immediately below.
Figure 1A schematically shows a photovoltaic panel using cells configured in accordance with illustrative embodiments of the invention.
Figure 1B schematically shows a pair of photovoltaic cells configured in accordance with illustrative embodiments of the invention.
Figure 2A schematically shows a top view of a photovoltaic cell configured in accordance with illustrative embodiments of the invention.
Figure 2B schematically shows a bottom view of a photovoltaic cell configured in accordance with illustrative embodiments of the invention.
Figure 3 schematically shows the top view of the photovoltaic cell of Figure 2 with its tabs removed.
Figure 4 schematically shows an enlarged view of fingers and busbars in the photovoltaic cell of Figure 2.
Figure 5 shows a process of forming a photovoltaic cell in accordance with illustrative embodiments of the invention.
Figure 6 schematically shows a portion of the photovoltaic cell in accordance with illustrative embodiments of the invention.
Figure 7A schematically shows a cross-sectional view of an even smaller portion of the photovoltaic cell of Figure 6.
Figure 7B schematically shows a cross-sectional view of an alternative arrangement for securing a tab to a busbar.
Figure 8 schematically shows a top view of an alternative embodiment having discontinuous fingers.
Figure 9 schematically shows a side view of two photovoltaic cells that used a conductive sheet to connect their tabs in accordance with illustrative embodiments of the invention.
Figure 10 shows a process of electrically connecting the two photovoltaic cells of Figure 9 accordance with illustrative embodiments of the invention.
Figure 11 schematically shows the conductive sheet and one of the cells when executing step 1002 of figure 10.

### DESCRIPTION OF ILLUSTRATIVE EMBODIMENTS

In illustrative embodiments, a photovoltaic cell has fingers with average widths of less than about 95 microns. Such a design can tolerate unintended finger breaks by having a relatively high number of busbars (i.e., relatively densely positioned busbars) across the top face of the cell. In addition, the inventors were surprised to discover that, when used with thin fingers, busbars spaced no more than about 38 millimeters from their adjacent busbars markedly improved cell efficiency - regardless of whether the fingers had breaks.

To further improve performance, various embodiments form the busbars and/or fingers from multiple unconnected components. For example, the busbars may be formed from a plurality of regularly spaced pads in electrical contact with the fingers. Details of illustrative embodiments are discussed below.

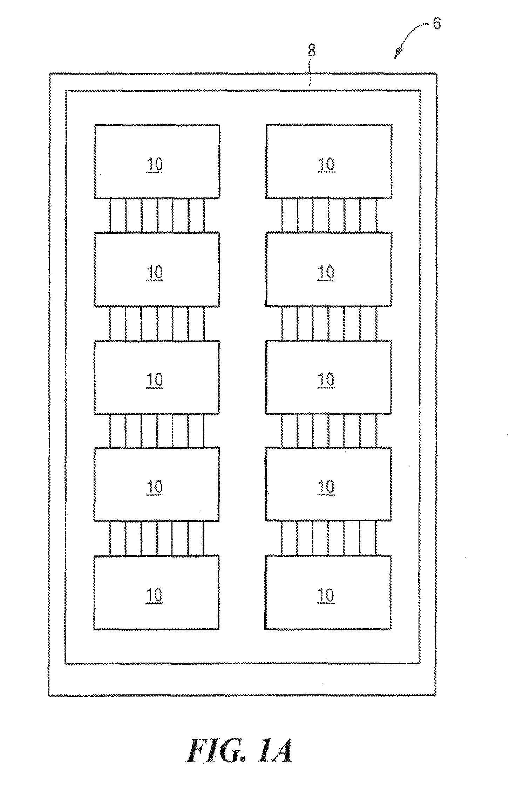

Figure 1A schematically shows a photovoltaic module 6 (also known as a photovoltaic panel 6 or solar panel 6) that may incorporate cells configured in accordance with illustrative embodiments of the invention. Among other things, the photovoltaic module 6 has a plurality of electrically interconnected photovoltaic cells within a rigid frame. The module 6 also may have an encapsulating layer (not shown) and glass top layer (not shown) to protect the cells, and a backskin (not shown) to further protect the cells and provide a back support.

It should be reiterated that the module 6 shown in Figure 1A serves merely as a schematic drawing of an actual module. Accordingly, the number of cells and, of course, the cell topology can vary significantly within the context of the below description.

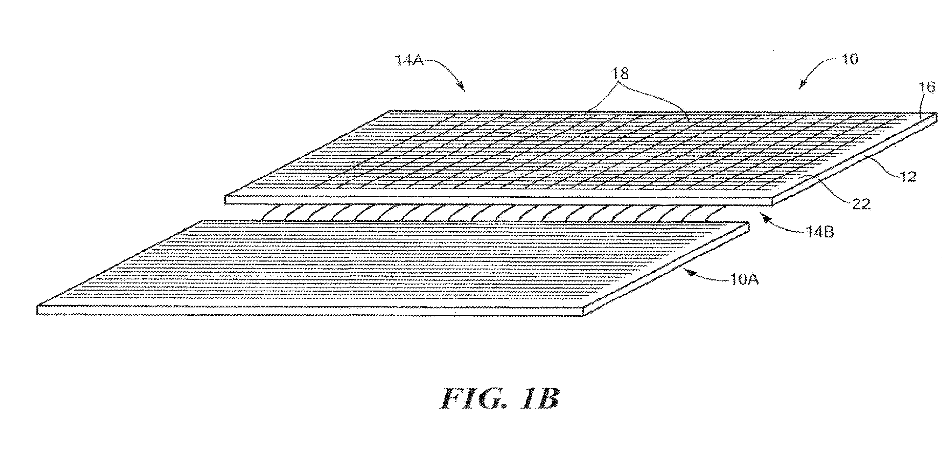

Figure 1B schematically shows a photovoltaic cell 10 configured in accordance with illustrative embodiments of the invention and connected to a second photovoltaic cell 10A. As an example, these two cells 10 and 10A both may be within the module 6 of Figure 1A. The two cells 10 and 10A may be configured in the same manner or in a different manner. In the example shown, the first and second photovoltaic cells 10 and 10A are serially connected to combine their power.

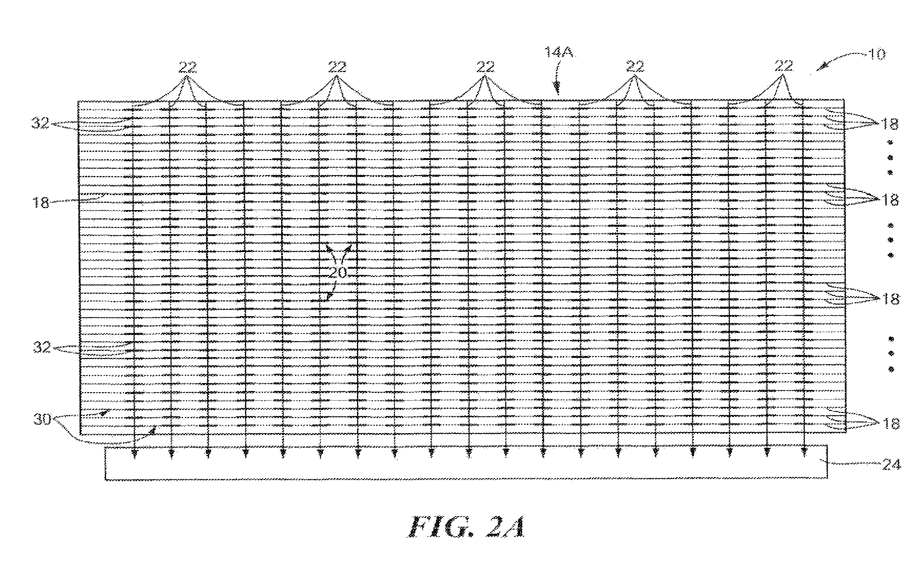

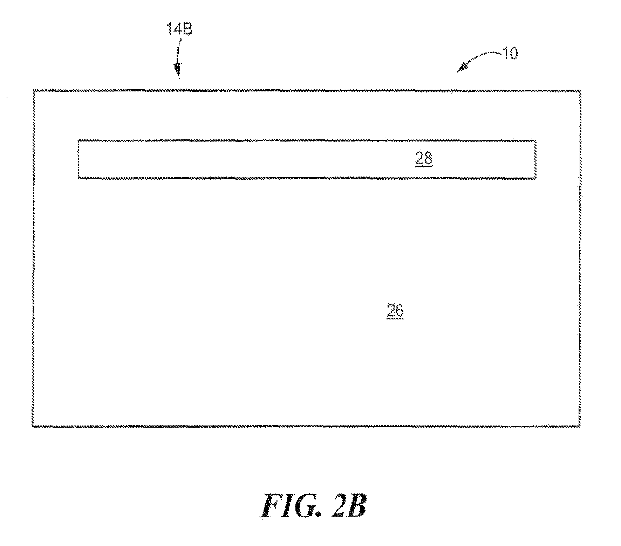

Among other things, the photovoltaic cell 10 has a doped substrate 12 with a plurality of conductors on its top and bottom faces/ surfaces 14A and 14B to collect and transmit electricity/current to an external device, such as another photovoltaic cell or an external load. More specifically, Figure 2A schematically shows a top view of the photovoltaic cell 10, while Figure 2B schematically shows a bottom view of the same photovoltaic cell 10. As shown, the top surface 14A has an antireflective coating 16 to capture more light incident light, and a pattern of deposited/integral conductive material to capture electric current.

Specifically, the conductive material includes a plurality of thin fingers 18 traversing generally lengthwise (horizontally from the perspective of the figure) along the substrate 12, and a plurality of discontinuous busbars 20 traversing a generally along the width (vertically from the perspective of the figure) of the substrate 12. As shown and discussed below, each of the busbars have regularly spaced discontinuities along their lengths. In the example shown, the busbars 20 are generally arranged in a pattern that is more or less perpendicular to the fingers 18.

Alternative embodiments, however, may form the busbars 20 and fingers 18 in different orientations. For example, the fingers 18, busbars 20, or both could traverse in a random manner across the top face 14A of the substrate 12, at an angle to the fingers 18 and busbars 20 shown, or in some other pattern as required by the application.

The photovoltaic cell 10 also has a plurality of tab conductors 22 (referred to generally as "tabs 22") electrically and physically connected to the busbars 20. For example, the tabs 22 may be formed from silver, silver plated copper wires, or silver plated copper wires to enhance conductivity. The tabs 22 transmit electrons gathered by the fingers 18 to a metallic strip 24, which is connectible to either an external load or another photovoltaic cell (e.g., as shown in Figure 1).

Illumination of the top face 14A of the substrate 12 generates carriers; namely, holes and electrons. As such, one goal for improving cell efficiency is to minimize the number of components shading/covering portions of the top face 14A. As discussed in greater detail below, the fingers 18, busbars 20, and tabs 22 are specially configured toward this goal.

The bottom face 14B of the substrate 12 does not receive light and thus, may be completely covered to maximize its efficiency in collecting charge carriers. Accordingly, as shown in Figure 2B, the bottom face 14B of the substrate 12 has a bottom surface metallic covering 26 (e.g., aluminum) with an exposed bottom contact 28 shaped to correspond with the shape of the prior noted metallic strip 24. The photovoltaic cell 10 therefore serially connects with similar photovoltaic cells by connecting their metallic strip 24 to its bottom contact 28, and/or by connecting its metallic strip 24 to their bottom contacts 28. The bottom contacts 28 may be embodied by one or more small pads to which the strip 24 is electrically connected.

In accordance with illustrative embodiments, the fingers 18 are much thinner than those known in the art. For example, some or all of the fingers 18 may have (average) thicknesses that are substantially less than about 120 microns. In fact, some embodiments have finger thicknesses of less than about 60 microns. During experiments and simulations, the inventors discovered that fingers 18 having thicknesses as low as about 80 microns, or even as low as 40 microns, still can produce satisfactory, commercially acceptable results when used with appropriately configured busbars 20. To that end, after significant experimentation and investment, the inventors were surprised to discover that their cell design with very thin fingers 18 sufficiently tolerated more finger breaks than cell designs having wider fingers, but different busbar arrangements.

In fact, as noted above, the inventors discovered that thin fingers (e.g., average widths of below about 95 microns) had significantly improved efficiency when used with busbars that are spaced no more than about 38 millimeters from their nearest/ adjacent busbars. More specifically, to the inventors' knowledge, no prior art cell design has successfully integrated thin fingers into a commercially viable device (i.e., a device with a currently favorable cost per watt). Others have tried but failed. For example, some have attempted to increase the conductivity of the fingers by using galvanic technology to form the fingers with two or more layers. Undesirably, however, such processes are very complex and add prohibitively increased costs to the per-watt cost of the cell. Others in the art simply teach away from using thin fingers and simply require fingers of between 100 microns and 1000 microns.

After much experimentation, the inventors discovered that they could use thin fingers having average widths of less than 100 microns, or even less than 95 microns (e.g., 60 microns or even 40 microns) as long as the busbars were sufficiently densely positioned across the top face. Otherwise, the art currently is unable to achieve commercially viable cells, at competitive pricing points, using thin fingers. Specifically, as previously noted, the inventors discovered that spacing the busbars no more than about 38 millimeters apart (from adjacent busbars) significantly improved efficiency and withstood finger breaks associated with thin fingers. Testing shows that results improved further with busbars having other smaller respective spacings, such as about 30 millimeters about 15 millimeters, about 10 millimeters, and about 7.5 millimeters. Of course, if the busbars become too dense, they will block too much light. Accordingly, the inventors also determined that if the busbars are no closer than about 6 millimeters, then the cell should provide the desired results.

The inventors realized that use of seven, eight, nine, or more (e.g., fifteen or more) closely spaced busbars 20 on a 80 millimeter X 150 millimeter cell could accomplish this favorable result. This increased number of busbars 20 thus further reduces the size of the finger segments 30 (discussed below) between the edge of the substrate 12 and a proximate busbar 20. As a result, the power loss (known as "Ohmic" or "Joule" loss) should be lower, and fewer electrons should be trapped in those regions, thus also improving cell efficiency.

Stated another way, busbars 20 intersect the fingers 18 to form finger segments 30. For example, two busbars 20 may intersect a single finger 18 to form a finger segment 30 between the two busbars 20. As another example, a single busbar 20 may intersect a finger 18 to form a finger segment 30 between the edge of the substrate 12 and the intersecting busbar 20. In the former case, the distance between the busbars 20 preferably is very short (e.g., between about 7 and 15 millimeters, but no more about 38 millimeters apart). If such a finger segment 30 breaks, then an electron on either side of the break still does not have a long distance to travel to reach one of its proximate busbars 20. It should be noted that some electrons still may be trapped if the single finger segment 30 has two breaks.

Alternative embodiments, however, do not require such thin fingers 18. For example, multiple busbars 20 or discontinuous busbars 20 (discussed below) still should improve efficiency even when used with high conductivity finger segments 30, or relatively wider fingers 18 (e.g., having widths greater than about 120 microns or having two or more layers).

Prior art busbars known to the inventors generally are formed as single, contiguous conductors in ohmic contact with multiple fingers 18. To ensure that they transmit a maximum number of electrons from the substrate 12, such busbars may traverse all of the fingers 18 (as also is the case with illustrative embodiments). Undesirably, however, such busbars cover an appreciable amount of the top face 14A of the substrate 12 -- a result antithetical to the above noted goal of minimizing such coverage.

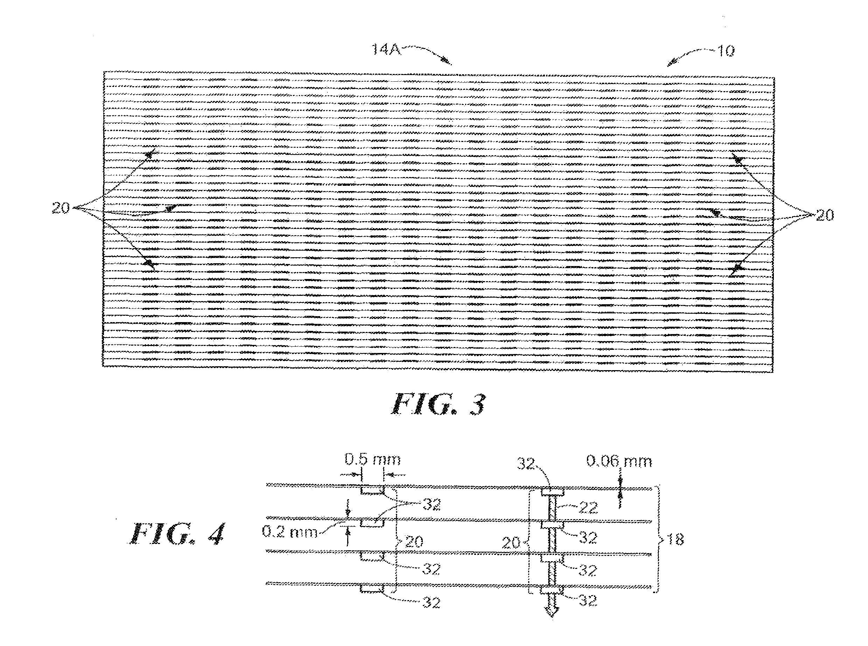

The inventors solved this problem by creating substantial discontinuities in their busbar 20, while still maintaining its functionality. Specifically, Figure 3 schematically shows the top face 14A of the substrate 12 with the tabs 22 removed to more clearly show the busbars 20. Figure 4 schematically shows an enlarged view of several fingers 18 and two busbars 20, with one busbar 20 coupled to a tab 22. As shown, each busbar 20 illustratively is formed from a plurality of separated, electrically isolated (across the top surface 14A of the substrate 12) conductive regions 32 that each are connected/integrated with a single finger 18. The conductive regions 32 may be any shape and size sufficient for coupling with a tab 22 (discussed below).

For example, Figure 4 schematically shows the busbars 20 as being formed from a plurality of electrically isolated pads (also referred to herein with reference number "32") in ohmic contact with the fingers 18. It should be noted that although characterized as "electrically isolated," these pads 32 may have some electrical connection through the substrate 12. Such a connection, however, is not a direct connection, such as that between the pads 32 and a finger 18.

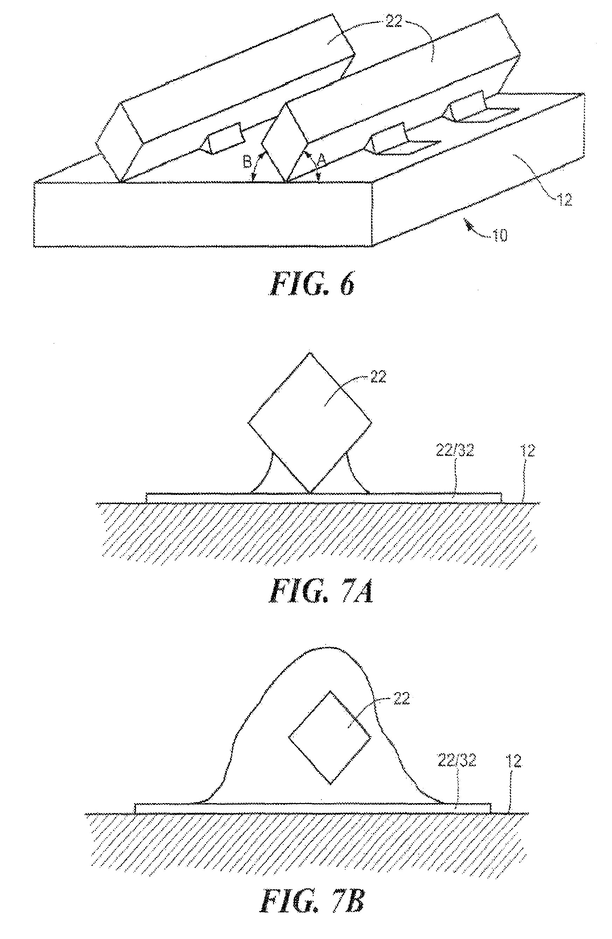

The pads 32 are sized to ensure that conventional soldering or similar processes can readily connect tabs 22 to them in a highly reliable and efficient manner (discussed in greater detail below with regard to Figures 6, 7A and 7B). As an example, each pad 32 of Figure 4 has a width of 500 microns and a (shorter) length of 200 microns. Such dimensions should provide a sufficient soldering site for connecting with relatively thin tabs 22 (e.g., tabs 22 having widths of approximately 150-200 microns) with reasonable tolerances. In some embodiments, the pads 32 are round with a diameter of between about 150 to 200 microns. Each busbar 20 thus comprises a plurality of regularly spaced pads 32. In other words, the pads 32 are spaced by a substantially constant amount (the busbars 20 have discontinuities that repeat on a periodic basis).

In the examples discussed and shown in Figures 2A and 2B, the photovoltaic cell 10 has 40 fingers and 19 busbars with 19 tabs. Accordingly, each busbar has 40 pads (i.e., one for each finger). If the substrate 12 is 80 millimeters by 150 millimeters, the fingers are 60 microns wide and 150 millimeters long, the tabs are 150 microns wide and 80mm long, and the pads each are 500 microns wide and 200 microns long, then the following shading occurs on the top surface 14A of the substrate 12:
- Finger shading: 40 fingers x 0.06mm width x 150 mm length= 360mm squared= 3 percent shading,
- Pad shading: 40 fingers x 19 busbars x 0.2mm length x 0.5mm width=76mm squared= about 0.6 percent shading,
- Tab shading: 0.15mm width x 80mm length x 19 tabs=228mm squared= about 1.9 percent shading.

To determine the total shading, however, the overlapping area between the pads 32 and the tabs 22 must be calculated and subtracted from the sum of the above three calculated areas. This overlapping area is determined as follows:
- Overlapping area: 0.2mm length of pad x 0.15mm width of tab x 40 pads x 19 tabs fingers= 22.8mm squared

Thus:
- Total shading for tabs and pads: 76mm-sq. + 228mm-sq. (minus) 22.8mm-sq= 281.2mm squared
- Total shading (ignoring, for simplicity, the overlap of the tabs and fingers): 360mm-sq. + 76mm-sq. + 228mm-sq. (minus) 22.8mm-sq= 641.2mm squared= about 5.3 percent shading.

In contrast, a corresponding prior art cell with a contiguous, 500 micron wide, 80 mm long busbar would have a busbar shading alone as follows:
- Prior art busbar shading: 0.5mm width x 80mm length x 19 busbars= 760mm squared=6.3 percent shading.

This prior art shading also includes tab shading since such tabs 22 are mounted on top of and within their busbars 20. Illustrative embodiments therefore favorably reduce substrate coverage by the busbars 20 in this example by more than 60 percent. Of course, total shading also must include the finger shading, which necessarily increases the above calculated prior art busbar 20 shading amount (6.3 percent). It should be reiterated that these specific numbers are illustrative and not intended to limit various embodiments of the invention. It thus is anticipated that illustrative embodiments can reduce the total shading of the substrate top surface 14A by the tabs 22, busbars 20 and fingers 18 together to be less than about six percent (e.g., between about five and six percent).

Accordingly, discontinuous busbars 20, such as those discussed above and shown in the figures, provide essentially the same function as prior art busbars while covering significantly less area of the top face 14A of the substrate 12. Moreover, as known by those skilled in the art, metallization on the top surface 14A of the substrate 12 often degrades the electrical quality of the substrate 12 immediately beneath the surface 14A. The significantly reduced coverage area of the discontinuous busbars 20 therefore should further reduce the likelihood of this adverse consequence.

It should be noted that the size, shape, and configuration of the discontinuous busbars 20 is not necessarily limited to the embodiments discussed above. For example, busbars 20 formed from pads 32 with larger or smaller widths or different shapes, among other things, still can suffice for various applications. In addition, some busbars 20 have irregularly spaced pads 32. Accordingly, discussion of specific examples is for illustrative purposes only and not intended to limit all embodiments of invention.

Some embodiments of the invention do not require discontinuous busbars 20. For example, some embodiments may have all contiguous busbars 20, or a combination of contiguous busbars 20 and discontinuous busbars 20.

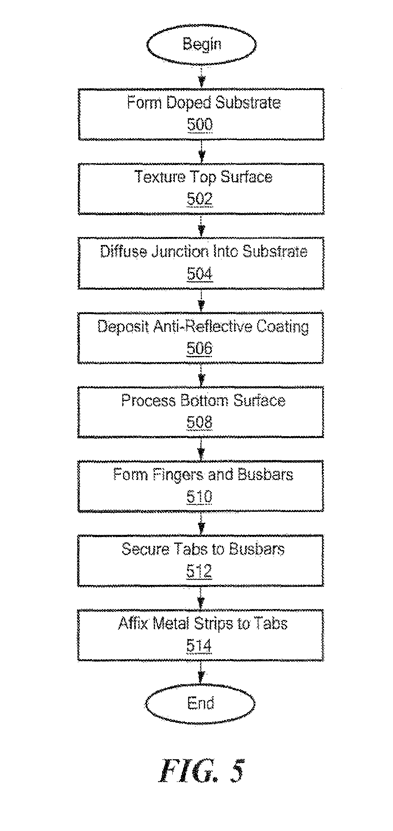

Figure 5 shows a process for forming the photovoltaic cell 10 in accordance with illustrative embodiments of the invention. It should be noted that for simplicity, this described process is a significantly simplified version of an actual process used to form a photovoltaic cell 10. Accordingly, those skilled in the art would understand that the process may have additional steps not explicitly shown in Figure 5. Moreover, some of the steps may be performed in a different order than that shown, or at substantially the same time. Those skilled in the art should be capable of modifying the process to suit their particular requirements.

The process begins at step 500, which forms a doped substrate 12. To that end, the process may form any kind of doped substrate appropriate for the intended purposes. Illustrative embodiments form a p-type doped string ribbon wafer, such as those produced by Evergreen Solar, Inc. of Marlborough, Massachusetts. As known by those skilled in the art, string ribbon wafers typically are very thin, such as on the order of between about 150 and 300 microns.

After cleaning the surfaces 14A and 14B of the wafer, the process continues to step 502 by texturing the top surface 14A to reduce its shininess. This step should reduce reflections that could minimize the amount of light that excites charged carriers. To that end, conventional processes create a microtexture on the top substrate surface 14A, giving it a "frosty" appearance.

Next, the process diffuses a junction into the substrate 12 (step 504). Specifically, embodiments using a P-type string ribbon wafer may form a very thin layer of N- type material to the top face 14A of the substrate 12. For example, this layer may have a thickness of about 0.3 microns. Among other ways, the process may apply this layer by spraying a phosphorous compound onto the top face 14A of the wafer, and then heating the entire substrate 12 in a furnace. Of course, the junctions may be formed by other means and thus, the noted techniques are discussed for illustrative purposes only.

After removing the substrate 12 from the furnace, the process continues to step 506 by depositing the above noted electrically insulating, antireflective coating 16 to the top face 14A of the substrate 12. In a manner similar to the noted texture, one primary function of the antireflective coating 16 is to increase the amount of light coupled into the photovoltaic cell 10. The antireflective coating 16 may be formed from conventional materials, such as silicon nitride.

The process then continues to step 508, which processes the bottom surface 14B of the substrate 12. To that end, conventional screen-printing processes first form a bottom contact 28 from a silver paste on the substrate 12, and then mask the bottom contact 28 to form the bottom surface metallic covering 26 (e.g., formed from aluminum).

Simultaneously, before, or after processing the bottom surface 14B, the process begins processing the top surface 14A by forming the arrays of fingers 18 and busbars 20 (step 510). To that end, illustrative embodiments screen-print a highly conductive paste over a mask on the top surface 14A of the substrate 12. The mask has the desired pattern for fingers 18 and busbars 20. Illustrative embodiments deposit one layer of conductive material only, although some embodiments can deposit multiple layers. To enhance conductivity, various embodiments use a silver paste to form the fingers 18 and busbars 20.

This step may deposit the fingers 18 as a substantially continuous line of the conductive material. Accordingly, fingers 18 formed this way should be free from breaks along their lengths. Despite these efforts, however, during or after processing, any of the fingers 18 may form one or more breaks along their lengths (referred to as "unintentional breaks"). Consequently, the resultant finger(s) 18 in turn often have one or more irregularly spaced breaks. Such breaks also may have irregular shapes.

Fingers 18 formed by processes to have no breaks thus are considered not to be discontinuous even if they have one or more such breaks. In other words, fingers engineered with spaces/discontinuities/breaks along their length, whether they are regularly or irregularly spaced, are considered to be discontinuous. In a corresponding manner, fingers engineered without spaces/discontinuities/breaks along their lengths are considered to be continuous-even if they have the noted unintentional breaks. The same discontinuous and continuous requirements also apply to busbars.

It should be noted that discussion of screen-printing is for illustrative purposes only. Some or all of the various discussed components can be applied using other technologies. Among other technologies, such embodiments may use inkjet printing or aerojet printing.

After screen-printing both surfaces 14A and 14B, the process passes the substrate 12 through a furnace at a high temperature for a short amount of time. For example, the process may pass the substrate 12 through a furnace at 850 degrees C for approximately 1 second. This short but quick heating effectively solidifies the conductive paste, and causes the conductive paste to "fire through" the antireflective coating 16. In other words, the conductive paste penetrates through the antireflective coating 16 to make ohmic contact with the substrate 12. Accordingly, the fingers 18 and busbars 20 contact the substrate 12 in a manner that causes their respective current-voltage curves to be substantially linear. Also of significance is the fact that the insulative qualities of the antireflective coating 16 prevent a direct electrical connection between two adjacent pads 32 across the top surface 14A. Of course, as noted above, adjacent pads 32 may have some electrical connection through the substrate 12, but such a connection is not the type of direct electrical connection provided by a wire, tab 22, or other direct electrical path.

The process then continues to step 512, which secures the tabs 22 to the busbars 20. To that end, conventional processes first may screen-print solder onto each of the pads 32, and then use a hotplate to melt the solder. At this stage, each pad 32 of a busbar 20 has a solder ball for receiving a tab 22. A scaffolding holding a row of tabs 22 under tension thus is moved downwardly to contact each solder ball with a tab 22. The solder balls then cool, consequently securing the tabs 22 to the pads 32. One advantage of using solder balls in this process is their ability to connect securely with the tabs 22 despite irregularities in the contour of the pads 32 and substrate 12.

It should be noted that the tabs 22 electrically connect indirectly with the substrate 12 via the pads 32 only. The insulative antireflective coating/layer 16 prevents the tabs 22 from directly electrically connecting with the substrate 12 through any other portion of the top surface 14A of the substrate 12.

The process concludes at step 514 by affixing the metal strip 24 (see Figure 2A) to the tabs 22. Any conventional means for making this connection should suffice, such as conventional soldering techniques.

The tabs 22 may be shaped in any of a number of different ways. For example, the tabs 22 may have a generally circular cross-sectional shape, such as that of a conventional wire. See the above noted co-pending US patent application assigned attorney docket number 3253/182, naming Brown Williams as inventor, and entitled, "SHAPED TAB CONDUCTORS FOR A PHOTOVOLTAIC CELL," for additional information about this embodiment.

Specifically, in accordance with illustrative embodiments, the tabs 22 have at least one generally planar side that generally forms an acute angle with the top surface 14A. More specifically. Figure 6 schematically shows one such embodiment with at least two tabs 22 having a rectangular, generally diamond shaped cross-sectional shape. As shown, the tabs 22 have at least two surfaces that each form acute angles A and B with the top surface 14A. This orientation favorably reflects some light reflected upwardly from the top surface 14A back to the top surface 14A, thus improving cell efficiency. In addition, this orientation may permit more light to reach the surface of the substrate.

The angles A and B may be the same or different. For example, both the angles A and B may be 45 degrees. As another example, angle A may be 60 degrees, while angle B may be 40 degrees. Accordingly, in such an example, the angle formed between the two relevant tab surfaces is 80 degrees. Angles A and B preferably each are greater than about zero degrees but less than about 90 degrees.

The surface(s) of the tab forming this relationship with the top surface 14A may be generally planar, or some other shape. For example, the tab 22 may have a surface with a concavity (not shown) that generally provides a similar effect. This concavity may have a very large effective radius, or a relatively small effective radius. In either case, the concavity may define a plane across its opening. In a manner similar to the substantially planar surfaces discussed above, this plane may form an acute angle with the surface 14A.

It should be noted that some surfaces of the tab 22 may be non-planar (e.g., have a generally convex, i.e., curved, shape). Moreover, various embodiments may take on a number of different cross-sectional shapes. For example, some embodiments may have a crass-sectional shape similar to that of any number of different polygons, such as triangles and octagons. In fact, some embodiments may use irregularly shaped tabs 22. Accordingly, discussion of diamond shaped or rectangular tabs 22 is for illustrative purposes only.

As noted above, illustrative embodiments solder the tabs 22 to the busbars 20. Figures 7A and 7B schematically show two different ways of soldering the tabs 22 to the busbars 20. Specifically, Figure 7A schematically shows a cross-sectional view of the arrangement of Figure 6 across one tab 22. As shown, solder contacts only the bottom part of the tab 22-- it does not completely encapsulate that entire portion of the tab 22. This is in contrast to the embodiment show in Figure 7B, in which solder completely encapsulates the entire portion of the tab 22.

The solder in both noted embodiments, however, only contacts specific portions of each tab 22 (referred to as "solder points"). Accordingly, significant portions of the tabs 22 are exposed and thus, not encapsulated. Those portions of the tabs 22 that are exposed therefore should provide most of the light reflection benefits discussed above. Specifically, those portions of the tabs 22 that are not exposed should reflect more light back to the top face 14A than conventional tabs, which have generally circular cross-sectional shapes.

In a manner discussed above with regard to other embodiments, solder connects securely with the tabs 22 despite irregularities in the contour of the substrate 12 and/or the busbars 22/32.

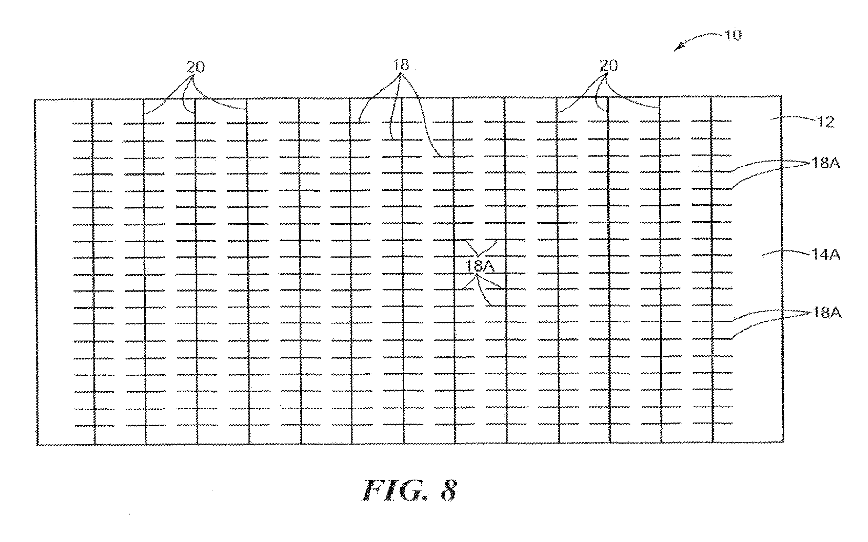

As noted above, various embodiments more readily tolerate breaks in the fingers 18 and, importantly, enable commercial use of thin figures. Figure 8 schematically shows the above noted alternative embodiment having a plurality of discontinuous fingers 18. Specifically, each finger 18 in this embodiment has a plurality of finger portions 18A that each intersects a busbar 20.

Stated another way, each pad 32 has at least one contiguous finger portion 18A extending therefrom. In illustrative embodiments, the pad 32 has some outer dimension that is greater than about 100 microns (e.g., about 500 microns), while the contiguous finger portion (i.e., contiguous to the pad 32) has an average thickness of less than about 95 microns. The finger portions 18A shown in Figure 8 form discontinuous fingers 18. The contiguous finger portions of other embodiments, however, may connect to firm a continuous finger 18.

As known by those skilled in the art, an electron has a diffusion length; i.e., the length it can travel during its lifetime. That distance in certain embodiments is approximately 1 millimeter. The spacing between each finger portion 18A of a given finger 18 (of the embodiment in Figure 8) therefore preferably is no greater than about two diffusion lengths; namely, about 2 millimeters in this case. By way of example only, the spacing may be between about 0.5 and about 2 millimeters. Of course, the spacing may be less than about 0.5 millimeters or greater than 2 millimeters.

As another example, in a system in which each busbar 20 is spaced about 9.8 millimeters from its adjacent a busbar 20, each finger portion 18A may have a length of about 7.8 millimeters. Accordingly, for a given finger 18 on that cell 10, each finger portion 18A is about 2 millimeters from its adjacent finger portion 18A. It should be reiterated that discussion of specific numbers and examples is illustrative and not intended to limit various embodiments of the invention.

In related embodiments, some fingers 18 on a single cell 10 are discontinuous while others on that same cell 10 are not discontinuous. In a similar manner, some fingers 18 may not extend entirely across the top face 14A of the cell 10. In particular, one busbar 20 may have 40 intersecting finger portions 18A, while another busbar 20 may have 35 intersecting finger portions 18A.

The discontinuous fingers 18 may be formed by any of a number of conventional techniques, such as those discussed above for forming continuous fingers 18. For example, conventional screen printing processes may form the discontinuous fingers 18.

This and related alternative embodiments thus further minimize coverage of the top face 14A, which enables more light to contact the cell 10. Cell efficiency consequently should improve when compared to embodiments having continuous fingers 18 (i.e., fingers without expressly engineered breaks). In fact, it is anticipated that efficiencies improve even further when combined with other embodiments, such as the discontinuous busbar embodiment, planar tab embodiment, and/or conductive sheet embodiment (discussed immediately below).

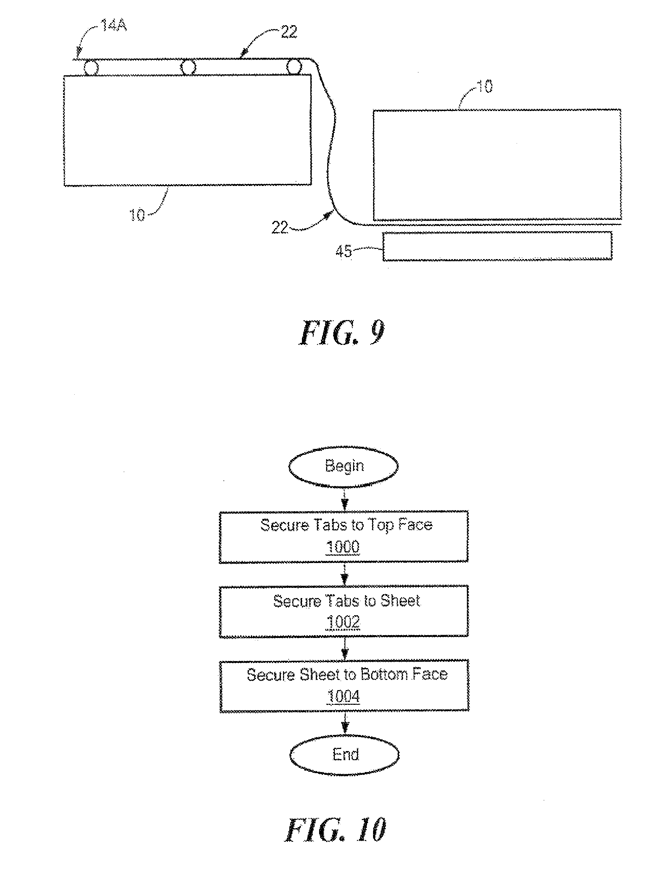

Various embodiments provide additional optimizations that further improve efficiency and reliability, while reducing manufacturing costs. Figures 9-11 show yet another such optimization using a conductive sheet 45, such as a conductive foil, to physically connect the tabs 22 with the bottom face 14B of the cell 10.

Specifically, Figure 9 schematically shows a side view of two cells 10 using a conductive sheet 45 as discussed above. As shown, a set of tabs 22 (i.e., one or more tabs 22) extends from the top face 14A of one of the cells 10 to the bottom face 14B of the immediately adjacent cell 10. The conductive sheet 45 secures these tabs to the bottom face 14B. It should be noted that for illustrative purposes only, Figure 9 is a somewhat exploded view because it spaces the conductive sheet 45 from the tab 22, which correspondingly is spaced from the bottom side of the cell 10. No such spacing should be present in the finished product.

The conductive sheet 45 may be any one of a variety of different conductive sheets known in the art. Among other things, the conductive sheet 45 may be a foil formed from a conductive material. For example, the foil may have a thickness of about 40 microns and be formed from a relatively pure copper. To physically connect with the tabs 22 and, ultimately, the bottom face 14B of the cell 10, the top surface of the conductive sheet 45 should have some adhesion material, such as a conductive adhesive or epoxy. This adhesion material may be formed across substantially the entire top surface of the conductive sheet 45, or in pre-specified locations.

For example, the conductive adhesive or epoxy may be formed from acrylic loaded with silver flakes and spread across substantially the entire top surface of the conductive sheet 45. Alternatively, the adhesive or epoxy may be formed from nickel coated glass fibers. Of course, other adhesives or epoxies should suffice, depending upon the requirements of the application.

Figure 10 shows a simplified, illustrative process of electrically connecting adjacent solar cells 10 in accordance with embodiments of the invention discussed with regard to Figure 9. In a manner similar to the process discussed above with regard to Figure 5, this described process is a significantly simplified version of an actual process used to connect two adjacent cells 10. Accordingly, those skilled in the art should understand that the process may have additional steps not explicitly shown in Figure 10. Moreover, some of the steps may be performed in a different order than that shown, or at substantially the same time. Those skilled in the art should be capable of modifying the process to suit their particular requirements.

Before beginning the process, the back face 14B of the cell 10 may be processed to enable a direct electrical connection with the substrate 12. One technique of doing this etches a plurality of holes through back dielectric layers (not shown) to the substrate 12. Such dielectric layers may be formed from, among other things, silicon nitride, a silicon oxide/silicon nitride stack, or other dielectric material. After forming the holes, the process adds aluminum (not shown) to the holes to make the electrical contact. The process of adding aluminum also may leave a thin layer of aluminum on the back face 14A of the cell 10.

The process then begins at step 1000 by securing the tabs 22 to the top face 14A of the cell 10. This may be completed a manner similar to step 512 of Figure 5, which describes using solder to connect the tabs 22 with the busbars 20. Other techniques, however, may connect the tabs 22 to the busbars 20.

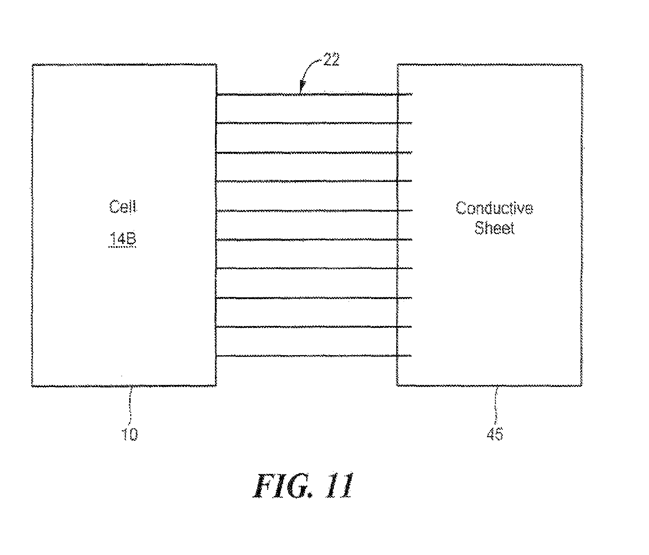

Before, during, or after completing step 1000, the process secures the tabs 22 to the conductive sheet 45. To that end, the tabs 22 have a length that permits them to extend over the top edge of the first cell 10 and to at least the edge of the top surface of the conductive sheet 45, as shown in Figure 11. The conductive adhesive should sufficiently secure the tabs 22 to the conductive sheet 45.

Alternatively, some embodiments may extend the tabs 22 across substantially the entire width of top surface of the conductive sheet 45, halfway across the width of the top surface of the conductive sheet 45, or to some other point across the width. From an electrical point of view, it does not matter where the tabs 22 are physically secured to the conductive sheet 45. From a mechanical point of view, however, it might be advantageous to extend the wires across some more significant fraction of the width of the conductive sheet 45 to ensure a reliable connection.

The process concludes at step 1004, which secures the top surface of the conductive sheet 45 to the bottom face 14B of the cell 10 as shown in Figure 9. When connected, the conductive sheet 45 is in intimate contact with the metal layer (e.g., aluminum layer) on the bottom face 14B of the cell 10. This intimate contact electrically connects the conductive sheet 45 with the aluminum, which electrically connects it with the substrate 12.

As shown, the width of the conductive sheet 45 may be smaller than the width of the cell 10. Alternatively, the width of the conductive sheet 45 may be the same size as the width of the cell 10. In other embodiments, the shape of the conductive sheet 45 does not necessarily correspond with the shape of the cell 10. For example, the conductive sheet 45 may have a round shape while the cell 10 has a rectangular shape.

As noted above, the conductive sheet 45 provides a number of advantages. Primarily, it provides a reliable mechanical connection that is relatively simple to implement. In addition, it provides high conductivity and low losses on the bottom face 14Bof the cell 10. Moreover, there is no need to have silver pads on the back face of the cell 10 (silver pads generally provide a solid soldering point), thus further improving efficiency and simplifying manufacturing.

Another benefit relates to the fragile nature of many solar cells 10. Specifically, the substrate 12 of many solar cells 10 break or crack when in the field. As known by those skilled in the art, a crack can isolate a section of the cell 10, thus preventing electrons formed by that portion of the cell 10 from contributing to cell power. Those skilled in the art thus often attempt to solve this problem by extending the tabs 22 substantially across the entire width of the bottom face 14B of the cell 10.

Use of the conductive sheet 45 obviates this need by ensuring that carriers from the noted isolated portions continue to electrically connect with the remainder of the cell 10. In fact, it is anticipated that the conductive sheet 45 will provide better conduction than conventional use of tabs 22. In addition to providing this reliability improvement, such embodiment must also reduces amount of wire used for the tabs 22 since it is no longer necessary to extend them across the substantial majority of the cell 10. This reduced use of wire consequently further minimizes manufacturing costs.

Some embodiments simply use a conductive adhesive without the conductive sheet 45 to connect the tabs 22 to the bottom face 14B of the cell 10.

Accordingly, illustrative embodiments should improve cell efficiency by one or a combination of several factors, including (among other things):
- use of thinner fingers 18,
- higher numbers of continuous and/or discontinuous busbars 20,
- tabs 22 oriented and shaped to reflect light back to the surface 14A,
- discontinuous fingers 18, and/ or
- a conductive sheet 45 to secure tabs 22 to the bottom face 14B of the cell 10.

The following numbered paragraphs form part of the disclosure.
1. A photovoltaic cell comprising:
   a photosensitive substrate;
   a plurality of fingers in ohmic contact with the substrate, at least one of the fingers having an average width of less than about 95 microns;
   a plurality of busbars in ohmic contact with the fingers,
   at least two of the busbars intersecting the at least one of the fingers, the at least two busbars being spaced less than about 38 millimeters apart.
2. The photovoltaic cell as defined by claim 1 wherein the at least two busbars are spaced no less than about six millimeters apart.
3. The photovoltaic cell as defined by claim 2 wherein no busbar on the substrate is spaced more than about 38 millimeters from another adjacent busbar.
4. The photovoltaic cell as defined by claim 1 wherein the plurality of busbars are generally equally spaced apart a given distance, the given distance being no more than about 15 millimeters.
5. The photovoltaic cell as defined by claim 1 wherein the substrate comprises a sheet wafer formed from doped polysilicon.
6. The photovoltaic cell as defined by claim 5 wherein the substrate comprises a string ribbon wafer.
7. The photovoltaic cell as defined by 1 wherein each of the plurality of intersected fingers has an average height of no greater than about twenty microns, and an average width of no greater than about sixty microns.
8. The photovoltaic cell as defined by 1 further comprising a plurality of tabs in ohmic contact with the plurality of busbars, the plurality of tabs having a generally planar surface that forms an acute angle with the substrate.
9. The photovoltaic cell as defined by 1 wherein at least one of the busbars is discontinuous and comprises a plurality of spaced pads.
10. The photovoltaic cell as defined by 1 wherein at least one of the fingers has a repeating discontinuity.
11. The photovoltaic cell as defined by 1 wherein each busbar and each finger comprises a screen printed conductive material.
12. The photovoltaic cell as defined by 1 wherein each of the plurality of fingers has an average width of no greater than about 65 microns.
13. The photovoltaic cell as defined by 1 wherein the substrate has a bottom face, the photovoltaic cell further comprising:
   a conductive sheet secured to the bottom face of the substrate; and
   a tab between the conductive sheet and the bottom face of the substrate.
14. The photovoltaic cell as defined by 1 wherein the substrate has an average thickness that is no greater than about 300 microns.
15. The photovoltaic cell as defined by 1 further comprising a plurality of tabs connected with the busbars, the substrate having a top surface containing the fingers and busbars, the fingers, tabs and busbars together covering no more than about six percent of the top surface of the substrate.
16. The photovoltaic cell as defined by 1 wherein the at least one finger has an average width of no less than about 35 microns.
17. The photovoltaic cell as defined by 1 wherein the plurality of fingers comprise only a single layer of conductive material.
18. A method of fabricating a photovoltaic cell, the method comprising:
   providing a photosensitive substrate having a top face;
   depositing a plurality of fingers onto the top face of the substrate and into ohmic contact with the substrate, the plurality of fingers each having an average width of less than about 95 microns; and
   depositing a plurality of busbars on the top face of the substrate to intersect the plurality of fingers, the plurality of busbars having an outer dimension of greater than about 95 microns, at least two of the plurality of busbars being deposited on the top face of the substrate so that they are separated by no more than about 38 millimeters.
19. The method as defined by 18 wherein depositing a plurality of fingers comprises depositing no more than one layer of conductive material onto the substrate to form the fingers.
20. The method as defined by 19 further comprising electrically connecting a tab to at least one of the one layer fingers.
21. The method as defined by 19 wherein the conductive material comprises a silver based material.
22. The method as defined by 18 wherein depositing a plurality of fingers comprises screen printing the fingers onto the top face of the substrate.
23. The method as defined by 18 wherein the plurality of busbars are spaced no less than about six millimeters apart.
24. The method as defined by 18 wherein no busbar on the substrate is spaced more than about 38 millimeters from another adjacent busbar.
25. The method as defined by 18 wherein providing comprises providing a string ribbon wafer formed from polysilicon.
26. The method as defined by 18 wherein depositing a plurality of fingers comprises depositing a substantially continuous line of conductive material across the front face of the substrate to form a single, substantially continuous finger.
27. The method as defined by 26 wherein the single, substantially continuous finger has an irregular break formed after depositing the plurality of fingers.
28. The method as defined by 18 wherein depositing a plurality of fingers comprises depositing a line of conductive material to have a regularly spaced discontinuity.
29. The method as defined by 18 wherein depositing a plurality of busbars comprises depositing fifteen busbars on the top face of the substrate.
30. The method as defined by 18 wherein depositing a plurality of busbars comprises depositing a plurality of spaced pads on the top face of the substrate.
31. The method as defined by 18 further comprising electrically connecting a plurality of tabs to the plurality of busbars.
32. The method as defined by 31 wherein each one of the plurality of tabs has a generally planar surface that forms an acute angle with the substrate when electrically connected.
33. The method as defined by 18 wherein the substrate has a bottom face, the method further comprising:
   securing a conductive sheet to the bottom face of the substrate; and
   securing a tab between the conductive sheet and the bottom face of the substrate.
34. The method as defined by 18 wherein depositing a plurality of fingers comprising depositing the plurality of fingers to have an average width of no less than about 35 microns.
35. A photovoltaic cell comprising:
   a photosensitive substrate;
   a plurality of current collecting means in ohmic contact with the substrate, at least one of the collecting means having an average width of less than about 95 microns;
   a plurality of tab connection means in ohmic contact with the fingers,
   at least two of the tab connection means intersecting a plurality of the fingers, the at least two tab connection means being spaced less than about 38 millimeters apart.
36. The photovoltaic cell as defined by 35 wherein the at least two tab connection means are spaced no less than about six millimeters apart.
37. The photovoltaic cell as defined by 35 wherein no tab connection means on the substrate is spaced more than about 38 millimeters from another adjacent tab connection means.
38. A photovoltaic cell comprising:
   a photosensitive substrate;
   a plurality of spaced pads in ohmic contact with the substrate, the plurality of pads forming a plurality of discontinuous busbars, each of the plurality of pads having an outer dimension that is greater than 100 microns,
   each pad in a set of the plurality of pads having a contiguous finger portion extending therefrom, each contiguous finger portion having an average width of no greater than about 95 microns.
39. The photovoltaic cell as defined by 38 wherein the finger portions form a discontinuous finger comprising a repeating discontinuity.
40. The photovoltaic cell as defined by 38 wherein a first finger portion of a first pad has a first end, a second finger portion of a second pad having a second end, the first end being spaced no more than about two electron diffusion lengths from the second end.
41. The photovoltaic cell as defined by 38 further comprising a plurality of tabs secured to the plurality of pads.
42. The photovoltaic cell as defined by 38 wherein at least two of the busbars are spaced less than about 38 millimeters apart.
43. The photovoltaic cell as defined by 38 wherein the finger portions of the set of the pads form a single continuous finger.
44. The photovoltaic cell as defined by 43 wherein the single continuous finger has at least one irregularly repeating discontinuity.
45. The photovoltaic cell as defined by 38 wherein each pad and each finger portion comprises a screen printed conductive material.
46. The photovoltaic cell as defined by 38 wherein the substrate comprises a string ribbon crystal wafer.
47. The photovoltaic cell as defined by 38 wherein the finger portions have only a single layer of conductive material.
48. The photovoltaic cell as defined by 38 wherein each of the plurality of finger portions has an average height of no greater than about twenty microns, and an average width of no greater than about sixty microns.
49. The photovoltaic cell as defined by . 38 further comprising a plurality of tabs in ohmic contact with the plurality of busbars, the plurality of tabs having a generally planar surface that forms an acute angle with the substrate.
50. The photovoltaic cell as defined by 38 wherein each of the finger portions has an average width of less than about 65 microns.
51. The photovoltaic cell as defined by 38 wherein the substrate has a bottom face, the photovoltaic cell further comprising:
   a conductive sheet secured to the bottom face of the substrate; and
   a tab between the conductive sheet and the bottom face of the substrate.
52. A photovoltaic panel comprising:
   a plurality of electrically connected photovoltaic cells,
   at least one of the photovoltaic cells comprising:
   a photosensitive substrate;
   a plurality of fingers in ohmic contact with the substrate, at least one of the fingers having an average width of less than about 95 microns; and
   a plurality of busbars in ohmic contact with the fingers,
   at least two of the busbars intersecting a plurality of the fingers, the at least two busbars being spaced less than about 38 millimeters apart.
53. The photovoltaic cell as defined by 52 wherein the at least two busbars are spaced no less than about six millimeters apart.
54. The photovoltaic cell as defined by 52 wherein no busbar on the substrate is spaced more than about 38 millimeters from another adjacent busbar.

## Claims

1. A photovoltaic cell comprising:
a photosensitive substrate;
a plurality of fingers in ohmic contact with the substrate, at least one of the fingers having an average width of less than about 95 microns;
a plurality of busbars in ohmic contact with the fingers, the busbars having an outer dimension in a range from 100 microns to 500 microns,
the busbars intersecting the fingers, the busbars being spaced less than about 38 millimeters apart, but no closer than 6 mm apart

2. The photovoltaic cell as defined by claim 1 wherein the plurality of busbars are generally equally spaced apart a given distance, the given distance being no more than about 15 millimeters.

3. The photovoltaic cell as defined by claim 1 wherein the substrate comprises a sheet wafer formed from doped polysilicon.

4. The photovoltaic cell as defined by claim 1 wherein each of the plurality of intersected fingers has an average height of no greater than about twenty microns, and an average width of no greater than about sixty microns.

5. The photovoltaic cell as defined by claim 1 wherein at least one of the busbars is discontinuous and comprises a plurality of spaced pads.

6. The photovoltaic cell as defined by claim 1 wherein at least one of the fingers has a repeating discontinuity.

7. The photovoltaic cell as defined by claim 1 wherein each busbar and each finger comprises a screen printed conductive material.

8. The photovoltaic cell as defined by claim 1 wherein each of the plurality of fingers has an average width of no greater than about 65 microns.

9. The photovoltaic cell according to claim 1 further comprising:
a plurality of tab connection means in ohmic contact with the fingers,
at least two of the tab connection means intersecting a plurality of the fingers, the at least two tab connection means being spaced less than about 38 millimeters apart.

10. The photovoltaic panel comprising:
a plurality of electrically connected photovoltaic cells according to claim 1.

11. A method of fabricating a photovoltaic cell, the method comprising:
providing a photosensitive substrate having a top face;
depositing a plurality of fingers onto the top face of the substrate and into ohmic contact with the substrate, the plurality of fingers each having an average width of less than about 95 microns; and
depositing a plurality of busbars on the top face of the substrate to intersect the plurality of fingers, the plurality of busbars having an outer dimension in a range from 100 microns to 500 microns, the busbars being deposited on the top face of the substrate so that they are separated by no more than about 38 millimeters, but no closer than 6 mm apart.

12. The method as defined by claim 11 wherein depositing a plurality of fingers comprises screen printing the fingers onto the top face of the substrate.

13. The method as defined by claim 11 wherein depositing a plurality of fingers comprises depositing a line of conductive material to have a regularly spaced discontinuity.

14. The method as defined by claim 11 further comprising electrically connecting a plurality of tabs to the plurality of busbars.

15. The method as defined by claim 14 wherein each one of the plurality of tabs has a generally planar surface that forms an acute angle with the substrate when electrically connected.

16. The method as defined by claim 11 wherein depositing a plurality of fingers comprises depositing the plurality of fingers to have an average width of no less than about 35 microns.
